# DEMANDE DE BREVET EUROPEEN

(11) **EP 0 928 031 A1**
(43) Date de publication de la demande: **07.07.1999**
(21) Numéro de dépôt: 98403321.7
(22) Date de dépôt: 29.12.1998
(51) Int. Cl.: H01L 31/09, G01J 5/20

(54) **Détecteur thermique bolométrique**

(30) Priorité: 31.12.1997 FR 9716791
(71) Demandeur: COMMISSARIAT A L'ENERGIE ATOMIQUE, 75015 Paris (FR)
(72) Inventeur: Ouvrier-Buffet, Jean-Louis, 74320 Sevrier (FR); Yon, Jean-Jacques, 38360 Sassenage (FR)
(74) Mandataire: Des Termes, Monique

(57) **Abrégé**

L'invention concerne un détecteur thermique bolométrique, comportant une partie active composée d'au moins deux électrodes coplanaires (8, 10) disposées en contact électrique avec une première couche mince semi-conductrice (6), dopée par un premier dopant d'un premier type de conductivité, d'une deuxième couche mince semi-conductrice (4), dopée comme la première couche, ou non dopée, et d'une troisième couche mince semi-conductrice (2) dopée par un deuxième dopant d'un deuxième typé de conductivité opposé au premier, la deuxième couche (4) étant disposée entre la première (6) et la troisième (2) couches.

## Description

### Domaine technique et art antérieur

L'invention concerne les détecteurs thermiques bolométriques, par exemple pour détecter les rayonnements infrarouges et/ou nucléaires (rayons X, γ, neutrons, etc...).

Les détecteurs infrarouges comportent généralement un élément sensible pouvant être chauffé par un rayonnement infrarouge dans la bande III (8 à 12 µm), caractéristique de la température et de l'émissivité des corps observés. L'augmentation de température de l'élément sensible engendre une variation d'une propriété électrique du matériau sensible : il y a apparition de charges électriques par effet pyroélectrique, variation de capacité par changement de la constante diélectrique, ou variation de la résistance d'un matériau semi-conducteur ou métallique.

Une faible masse calorifique du matériau sensible, une bonne isolation thermique de la couche active vis-à-vis de son support (ces deux premières conditions impliquant une mise en oeuvre en couche mince) et, enfin, une forte sensibilité de l'effet de conversion de l'échauffement en signal électrique (TCR pour une résistance) permettent en général d'assurer un fonctionnement performant de ces détecteurs.

Des imageurs infrarouges monolithiques fonctionnant à température ambiante sont fabriqués en connectant directement une matrice d'éléments sensibles à un circuit de multiplexage en silicium de type CMOS ou CCD.

Le détecteur thermique peut être encapsulé, sous vide ou sous un gaz peu conducteur de la chaleur, pour gagner en performance. Le boîtier comporte alors une fenêtre transparente dans la bande III.

Dans les détecteurs bolométriques de type résistifs, le rayonnement incident absorbé provoque une augmentation de la température du détecteur, qui induit à son tour une variation de la résistance électrique. Ces variations de résistance engendrent des variations de tension ou de courant aux bornes du détecteur, qui constituent le signal délivré par le capteur.

La demande FR-95 07151 décrit une structure bolométrique de type résistif mettant en oeuvre un matériau semi-conducteur. Le matériau sensible peut être du silicium polycristallin ou amorphe, de type p ou n, faiblement ou fortement résistif. Il peut s'agir également d'un oxyde de vanadium (V205, VO2) élaboré dans une phase semi-conductrice.

Généralement le matériau sensible repose sur un support isolant (SiO₂, SiO, SiN, ZnS, etc.) qui assure la rigidité mécanique de la structure bolométrique. Il peut aussi être totalement encapsulé avec l'un de ces matériaux isolants.

Afin de rendre la valeur de la résistance compatible avec les caractéristiques du circuit de lecture, il existe diverses configurations d'électrodes qu'on peut classer en deux grandes catégories :
- les détecteurs à électrodes coplanaires (comme dans la demande FR-96 10005),
- les détecteurs à électrodes en regard (sandwich).

La présente invention se rapporte à la première catégorie de détecteurs.

Il se pose le problème, pour ces dispositifs, d'obtenir un bon contact ohmique avec le semi-conducteur dopé. Or le dopage du semi-conducteur diminue son coefficient de température TCR.

Pour obtenir un contact ohmique, qui permet le passage du courant dans les deux directions avec une chute de potentiel négligeable au niveau de la région de contact, on cherche à :
- réduire autant que possible la hauteur de la barrière par un choix judicieux du métal utilisé.
- réduire l'épaisseur de la zone de charge d'espace (ou encore désertion ou déplétion) en dopant fortement le semi-conducteur près du contact.

Afin de réaliser des détecteurs bolométriques à fort coefficient de température l'homme de l'art utilise classiquement un matériau peu dopé, dans lequel les contacts ohmiques seront obtenus par un surdopage local, réalisé par les techniques d'implantation ou de diffusion. Ces techniques sont, d'une part, relativement lourdes à mettre en oeuvre, et d'autre part nécessitent des traitements thermiques à hautes températures incompatibles avec une technologie bolométrique assemblée sur un circuit de multiplexage en silicium de type CMOS ou CCD.

Une alternative consiste à utiliser une double couche, de type matériau peu dopé/matériau dopé, les régions de contact étant définies par gravure. Toutefois cette technique est extrêmement difficile à utiliser du fait de l'absence de sélectivité entre les deux couches, et du fait de leurs faibles épaisseurs.

### Exposé de l'invention

L'invention a pour objet un détecteur thermique bolométrique ainsi qu'un dispositif de détection bolométrique ayant un bon contact ohmique et un bon coefficient de température (TCR).

L'invention a également pour objet de réaliser une structure de détection de type bolométrique de manière simple, à faible coût, tout en garantissant de très bons contacts ohmiques, donc peu générateurs de bruit à basse fréquence.

Pour conserver un bon contact ohmique et un bon TCR, l'invention propose de dépeupler de porteurs la zone inter-électrodes par l'utilisation d'une couche semi-conductrice de dopage de type opposé à celui de la couche inter-électrodes.

Le capteur ou détecteur thermique bolométrique selon l'invention comporte donc une partie active composée d'au moins deux électrodes coplanaires en contact électrique avec une première couche mince semi-conductrice, dopée par un premier dopant d'un premier type de conductivité, d'une deuxième couche mince semi-conductrice, dopée comme la première couche, ou non dopée, en contact électrique avec les électrodes, et d'une troisième couche mince semi-conductrice dopée par un deuxième dopant d'un deuxième type de conductivité opposé au premier, la deuxième couche étant disposée entre la première et la troisième couches.

D'un point de vue électrique, la différence de potentiel appliquée entre les électrodes fait circuler un courant dans la zone inter-électrodes définie dans les première et deuxième couches (si la deuxième couche est dopée), la troisième couche étant à un potentiel flottant.

L'invention a donc pour objet un détecteur thermique bolométrique, à électrodes coplanaires et l'introduction, dans un tel détecteur ou bolomètre, d'une couche active qui en modifie son fonctionnement. Son principal avantage est d'obtenir des matériaux à fort coefficient de température, à partir de couches relativement conductrices, et donc plus simplement exploitable d'un point de vue technologique.

La présence de deux semi-conducteurs de type opposé distingue la structure de l'invention des structures traditionnelles. En effet, dans l'art antérieur, le matériau bolométrique peut être encapsulé entre deux couches de matériau isolant comme du SiN, du Si₃N₄ ou du SiO. Toutefois, ces couches ne modifient pas de manière contrôlée les propriétés du matériau bolométrique.

La position du niveau de Fermi dans le gap des matériaux semi-conducteurs est un paramètre déterminant pour les propriétés de conductivité de ces matériaux. Ainsi, le courant traversant la structure est limité par la région la plus résistante, comme une région dépeuplée. La nature des contacts ou bien la création d'une région dépeuplée par une structure appropriée sont susceptibles de modifier la conductivité initiale de ces matériaux. Aussi, à cette fin, l'invention propose de générer des régions dépeuplées de porteurs en encapsulant le matériau bolométrique, au moins sur l'une de ses faces, avec un matériau pouvant générer une zone de charge d'espace (matériau semi-conducteur de type de conductivité opposé, oxyde chargé, matériau métallique).

L'invention est destinée en particulier aux détecteurs bolométriques réalisés sur un circuit de lecture. Ces bolomètres sont généralement élaborés à basse température (typiquement <450°C). Il en résulte que les matériaux mis en oeuvre se présentent sous forme amorphe, microcristalline, ou polycristalline, et sont de faible épaisseur, afin de limiter la capacité calorifique.

Le détecteur selon l'invention peut être par exemple un détecteur de rayonnement de type infrarouge.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- La figure 1 représente schématiquement le principe d'un détecteur selon l'invention.
- Les figures 2 et 3 représentent deux variantes d'un détecteur selon l'invention.
- Les figures 4 et 5 représentent des structures à micropont réalisées par gravure d'un substrat ou à partir d'une couche sacrificielle.

### Description détaillée de modes de réalisation de l'invention

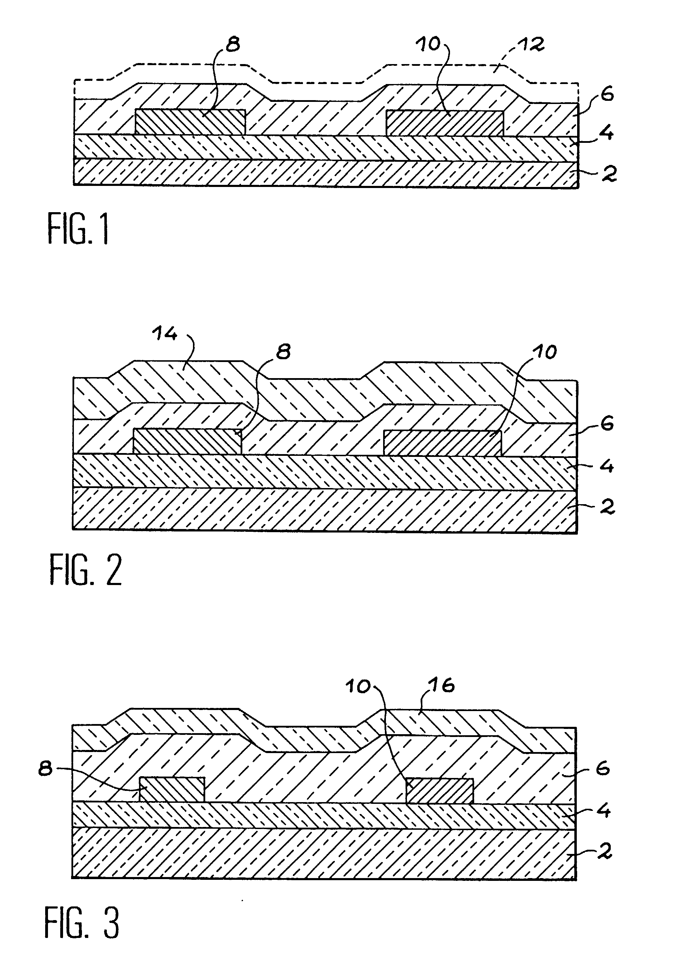

Un exemple de capteur, ou de bolomètre, selon l'invention comporte deux couches semi-conductrices 4, 6 de même type de conductivité (p ou n) ; ou bien une couche semi-conductrice dopée 6 (type p ou n) et une couche de matériau semi-conducteur intrinsèque 4. L'ensemble enferme des électrodes métalliques 8, 10 comme l'indique la figure 1. Cet arrangement permet d'éviter la formation d'une diode parasite qui conduirait à des caractéristiques courant-tension non linéaires. Bien entendu d'autres dispositions sont possibles.

Une couche de matériau semi-conducteur 2, de conductivité opposée à celle des couches 4, 6, et non reliée à une alimentation, induit une région dépeuplée de porteurs entre les électrodes 8, 10, peu conductrice de l'électricité et donc associée à un fort coefficient de température (à une forte énergie d'activation). De plus, cette couche supplémentaire ne risque pas de court-circuiter la couche initiale car, pour les porteurs de charge, cette structure peut être interprétée comme le montage de deux diodes tête-bêche.

Éventuellement, une couche isolante 12 réalise une passivation du dispositif.

Cette structure se comporte comme une résistance R=ρL/S où L est la distance inter-électrode, ρ la résistivité de la zone inter-électrode et S sa section. L'énergie d'activation du courant est celle des porteurs majoritaires (trous pour un matériau de type p), tant qu'on est loin du régime de charge d'espace. En d'autres termes, il existe une valeur du champ électrique critique au-delà de laquelle le courant est limité par ce mécanisme, qui entraîne une distribution non homogène du champ électrique et de la densité de porteurs. En-dessous de cette valeur de champ critique, le comportement est ohmique, donc activé en température.

Une telle réalisation permet de conduire relativement simplement à des structures du type métal-semi-conducteur p(n)-région dépeuplée-semi-conducteur p(n)-métal, et dont les propriétés principales sont les suivantes :
- la conduction est assurée par un seul type de porteurs,
- les contacts du type métal-semi-conducteur p(n) sont ohmiques,
- l'interface semi-conducteur p(n)-région dépeuplée est une homojonction,
- la région dépeuplée entraîne un accroissement de l'énergie d'activation du dispositif.

Dans une structure selon l'invention, l'épaisseur des régions dépeuplées est d'une part supérieure à l'épaisseur des couches et, d'autre part, les électrodes constituées de matériau métallique limitent l'extension de la zone de charge d'espace. Ainsi, les régions situées au-dessus de la cathode et de l'anode (c'est-à-dire au-dessus des électrodes) ne sont pas dépeuplées, contrairement à ce qui se produit dans l'espace inter-électrodes.

La maîtrise de l'extension de la zone de charge d'espace est assurée par le niveau de dopage respectif des couches en présence. Une région est complètement dépeuplée si son épaisseur est inférieure à l'extension de la zone de charge d'espace. Typiquement, l'épaisseur des couches de matériaux semi-conducteurs et métalliques, utilisées dans la présente invention, est comprise entre 5.10⁻³ (µm) et 1 µm. La distance entre les électrodes se situe entre 0,1 (µm) et 10 µm.

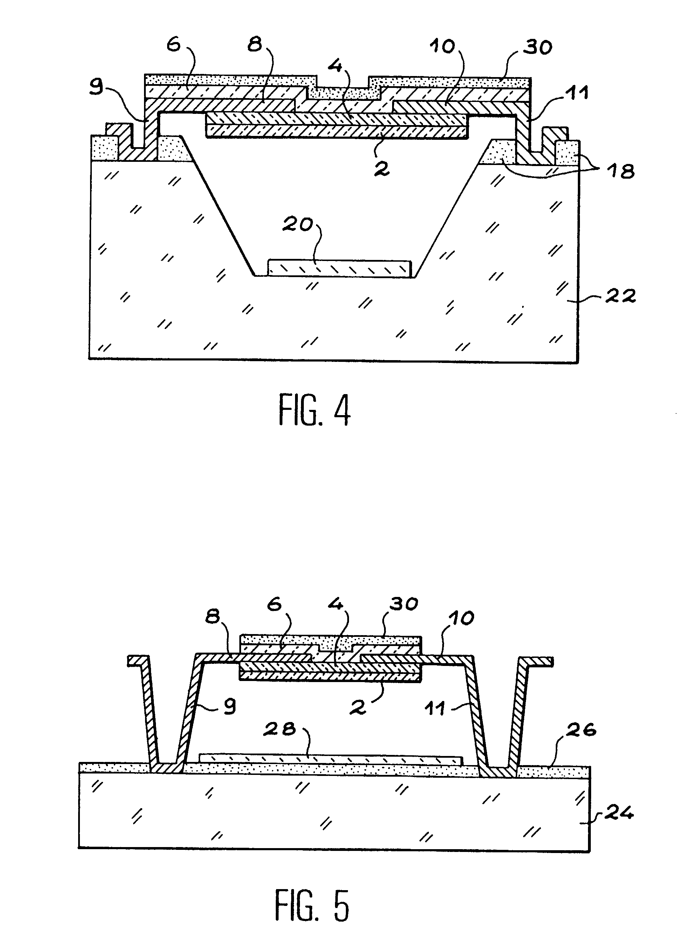

Deux variantes de l'invention peuvent être considérées. La première variante (figure 2) concerne une structure, symétrique en épaisseur (par rapport au plan de référence défini par l'interface des couches 4 et 6), simplement ou doublement dépeuplée.

La structure déjà décrite ci-dessus est recouverte d'une couche semi-conductrice 14 intrinsèque ou du type de conductivité identique à celui de la couche 2.

Cette structure assure la passivation des deux couches 4, 6 dans lesquelles circulent les porteurs ; de surcroît, les porteurs sont refoulés vers l'interface entre ces deux couches. La région inter-électrodes peut être complètement ou partiellement dépeuplée suivant les niveaux de dopage respectif des couches. Si la région inter-électrode est complètement dépeuplée, on assure une dissymétrie de dopage des couches 4, 6 ou 2 et 14 afin de garantir des contacts du type métal-semi-conducteur p(n) ohmiques. Par exemple, le dopage de la couché 6 est supérieur au dopage de la couche 4, lorsque les niveaux de dopage des couches 2 et 14 sont identiques. Ainsi, les régions au-dessus des électrodes ne sont pas totalement dépeuplées.

Enfin les couches 4 et 14 peuvent être réalisées avec un matériau faiblement dopé ou intrinsèque.

La deuxième variante (figure 3) concerne une structure active à épaisseur dissymétrique, doublement dépeuplée.

La structure de la figure 1 est recouverte d'une couche 16 semi-conductrice de type de conductivité identique à celui de la couche 2.

Cette configuration présente les mêmes avantages que la précédente, mais le contact ohmique est assuré cette fois en jouant sur les épaisseurs des couches 4, 6. Si la zone dépeuplée, générée par la couche 2, s'étend au-delà de la couche 4 de telle manière qu'elle rejoigne la zone de charge d'espace générée par la couche 16, il suffit alors que l'épaisseur de la zone de charge d'espace générée par la couche 16 reste inférieure à l'épaisseur de la couche 6 afin de réaliser des contacts ohmiques au niveau des électrodes. De plus, il est possible d'introduire une couche intermédiaire non dopée entre, d'une part, l'ensemble des couches 2 et 4 et, d'autre part, l'ensemble des couches 6 et 16.

Un détecteur thermique selon l'invention comporte un des empilements sensibles décrit précédemment, conduisant à un dispositif à fort coefficient de température, tout en s'affranchissant des problèmes de reprise de contact sur un matériau peu dopé. De surcroît les couches semi-conductrices non reliées à une alimentation assurent la passivation et le blindage des couches actives.

De tels détecteurs thermiques peuvent être répartis selon une architecture matricielle permettant de faire de l'imagerie, en particulier infrarouge (comme dans FR-96 10005 ou FR-95 07151).

L'utilisation de microstructures en couche mince permet de réaliser une isolation thermique efficace du capteur, ou de la matrice de capteurs, par rapport au substrat silicium ou au circuit de multiplexage. Par exemple, ces microstructures peuvent être élaborées suivant différents procédés qui conduisent à la fabrication de microponts :
- par sous-gravure du substrat de silicium 22 sous le senseur, isolant ainsi celui-ci partiellement du substrat (ou circuit de lecture) 22, comme le montre la figure 4. Sur cette figure, des références identiques à celles des figures 1 ou 2 y désignent des éléments identiques ou correspondants ; la référence 18 désigne une couche de passivation et la référence 20 un élément réflecteur situé au fond de la zone gravée. Les conducteurs 8 et 10 sont prolongés par des bras 9, 11 de maintien à une distance fixe du substrat 22,
- à partir d'une couche sacrificielle, typiquement en polyimide, sur laquelle est élaborée le senseur, et finalement attaquée comme l'illustre la figure 5. Sur cette figure, la référence 24 désigne un substrat (ou circuit de lecture) recouvert d'une couche de passivation 26. Un élément réflecteur 28 est réalisé sous le micropont. Les conducteurs 8, 10 sont prolongés par des bras 9, 11 de maintien, à une distance fixe du substrat 24.

Éventuellement, un élément absorbeur 30 est réalisé sur le détecteur.

En l'absence d'un tel absorbeur 30 placé au sommet de la structure, les électrodes jouent, avec le réflecteur 20, 28 (figures 4, 5) le rôle d'éléments absorbants du rayonnement (ici : infrarouge). Aussi, de même que pour l'absorbeur, la résistance par carré de la couche constituant les électrodes 8, 10, et la distance entre celles-ci et le réflecteur 20, 28, sont contrôlées de manière à réaliser une cavité quart d'onde conduisant au maximum d'absorption à la longueur d'onde de environ 10 µm.

Quel que soit le mode de réalisation envisagé, les couches minces (0,005 µm à 1 µm) des éléments sensibles, en matériau semi-conducteur, amorphe ou polycristallin (Si, Ge, Si:H, SiGe:H, SiC:H, etc.), peuvent être obtenues à l'aide des technique de dépôt à basse température, habituellement utilisées pour ces matériaux : pulvérisation cathodique, décomposition thermique (LPCVD) ou plasma (PECVD).

Le dopage de ces couches est réalisé en introduisant un gaz dopant (B₂H₆, PH₃, etc.) dans le réacteur ou bien par implantation ionique. La structure de détecteur selon l'invention peut être obtenue par une combinaison de toutes ces techniques.

Les électrodes 8, 10 (Ti, TiN, Pt, Pt-Si, Pd, Ni, NiCr, etc.) situées entre deux couches de matériau semi-conducteur, sont définies par gravure chimique ou plasma, ou par un procédé de "lift off". La géométrie de ces électrodes planaires détermine la valeur de la résistance du détecteur.

Enfin, ces électrodes peuvent être connectées à l'étage d'entrée d'un circuit de lecture par des procédés classiques de reprise de contact, et adaptées à la structure du micropont dans le cas des figures 4 et 5.

## Revendications

1. Détecteur thermique bolométrique, comportant une partie active composée :
- d'au moins deux électrodes coplanaires (8, 10) en contact électrique avec une première couche mince semi-conductrice (6), dopée par un premier dopant d'un premier type de conductivité,
- d'une deuxième couche mince semi-conductrice (4), dopée comme la première couche, ou non dopée en contact électrique avec les électrodes,
- et d'une troisième couche mince semi-conductrice (2) dopée par un deuxième dopant d'un deuxième type de conductivité opposé au premier, la deuxième couche (4) étant disposée entre la première (6) et la troisième (2) couches.

2. Détecteur selon la revendication 1, comportant en outre une couche (12) de passivation.

3. Détecteur selon la revendication 1, présentant une structure symétrique en épaisseur, simplement ou doublement dépeuplée.

4. Détecteur selon la revendication 1 ou 3, comportant en outre une couche semi-conductrice (14) intrinsèque ou de type de conductivité identique à celui de la troisième couche (2).

5. Détecteur selon la revendication 1, présentant une structure à épaisseur dissymétrique, doublement dépeuplée.

6. Détecteur selon la revendication 1 ou 5, la première couche mince semi-conductrice (6) étant recouverte d'une couche (16) semi-conductrice de type de conductivité identique à celui de la troisième couche mince (2).

7. Détecteur selon l'une des revendications précédentes, les couches semi-conductrices ayant chacune une épaisseur comprise entre 0,005 µm et 1 µm.

8. Dispositif de détection de type bolométrique comportant un détecteur selon l'une des revendications précédentes, réalisé sur un substrat ou un circuit de lecture (22, 24) et isolé thermiquement de celui-ci.

9. Dispositif selon la revendication 8, le détecteur et le substrat, ou circuit, présentant une structure de micropont.

10. Dispositif selon la revendication 9, le substrat, ou circuit, (22) étant gravé sous le détecteur.

11. Dispositif selon la revendication 10, un élément réflecteur (20) étant disposé au fond d'une portion gravée du substrat, ou circuit, (22).

12. Dispositif selon la revendication 9, le détecteur étant séparé du substrat ou du circuit de lecture (24) par la gravure d'une couche sacrificielle.

13. Dispositif selon la revendication 12, comportant en outre un élément réflecteur (28) disposé entre le détecteur et le substrat.

14. Dispositif selon l'une des revendications 8 à 13, comportant en outre, sur le capteur, un élément absorbant (30) du rayonnement infrarouge.

15. Structure de détection comportant un ensemble de détecteurs selon l'une des revendications 1 à 7 ou de dispositifs selon l'une des revendications 8 à 14, répartis selon une architecture matricielle.
